(19) Europäisches Patentamt
European Patent Office
Office européen des brevets

(11) **EP 3 421 933 B1**

(12) **FASCICULE DE BREVET EUROPEEN**

(45) Date de publication et mention
de la délivrance du brevet:
**19.08.2020   Bulletin 2020/34**

(51) Int Cl.:
***G01C 19/62*** *(2006.01)*

(21) Numéro de dépôt: **18179826.5**

(22) Date de dépôt: **26.06.2018**

(54) **PROCÉDÉ DE DÉTECTION D'UNE ROTATION AVEC DÉMARRAGE RAPIDE D'UN GYROSCOPE ATOMIQUE À POMPAGE SEOP**

ERKENNUNGSVERFAHREN EINER ROTATION MIT SCHNELLANLAUF EINES ATOMGYROSKOPS MIT OPTISCHEM SPINAUSTAUSCH-PUMPEN (SEOP)

METHOD FOR DETECTING ROTATION WITH QUICK STARTING OF A SEOP PUMPED ATOMIC GYROSCOPE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité:  **28.06.2017   FR 1755969**

(43) Date de publication de la demande:
**02.01.2019   Bulletin 2019/01**

(73) Titulaires:
• **Commissariat à l'énergie atomique et aux énergies alternatives
75015 Paris (FR)**
• **Safran
75015 Paris (FR)**

(72) Inventeur: **PALACIOS LALOY, Augustin
38000 Grenoble (FR)**

(74) Mandataire: **Brevalex
95, rue d'Amsterdam
75378 Paris Cedex 8 (FR)**

(56) Documents cités:
**WO-A1-2012/099819     WO-A1-2017/042544**

• **KORNACK T W ET AL: "Nuclear spin gyroscope based on an atomic co-magnetometer", ARXIV.ORG, CORNELL UNIVERSITY LIBRARY, 201 OLIN LIBRARY CORNELL UNIVERSITY ITHACA, NY 14853, 12 mai 2005 (2005-05-12), XP080194655, DOI: 10.1103/PHYSREVLETT.95.230801**
• **JIANCHENG FANG ET AL: "A novel Cs- 129 Xe atomic spin gyroscope with closed-loop Faraday modulation", REVIEW OF SCIENTIFIC INSTRUMENTS., vol. 84, no. 8, 1 août 2013 (2013-08-01), page 083108, XP055477797, US ISSN: 0034-6748, DOI: 10.1063/1.4819306**
• **BATZ M ET AL: "Fundamentals of metastability exchange optical pumping in helium", JOURNAL OF PHYSICS: CONFERENCE SERIES, INSTITUTE OF PHYSICS PUBLISHING, BRISTOL, GB, vol. 294, no. 1, 14 juin 2011 (2011-06-14) , page 12002, XP020206037, ISSN: 1742-6596, DOI: 10.1088/1742-6596/294/1/012002**

EP 3 421 933 B1

## Description

## DOMAINE TECHNIQUE

Le domaine de l'invention est celui des gyroscopes utilisés pour permettre la navigation inertielle, à savoir la navigation en l'absence de tout repère extérieur par l'intégration des équations du mouvement. L'invention concerne les gyroscopes à spin atomique qui utilisent les propriétés magnétiques des atomes pour réaliser des mesures de rotation, et plus particulièrement ceux du type à pompage optique par échange de spin (SEOP pour « Spin Exchange Optical Pumping »).

## ÉTAT DE LA TECHNIQUE ANTÉRIEURE

Les gyroscopes les plus couramment utilisées actuellement en navigation inertielle sont des gyroscopes optiques à effet Sagnac qui présentent cependant l'inconvénient d'être relativement encombrants. Ce n'est pas le cas des gyroscopes à spin atomique qui peuvent faire l'objet d'une miniaturisation et pourraient être utilisés dans de nombreuses applications innovantes, par exemple pour compléter des données GPS en milieu urbain à destination d'automobilistes ou de piétons, pour aider au repérage d'équipes de secours en milieu souterrain, pour augmenter l'autonomie de drones en milieu hostile, etc.

Les gyroscopes atomiques utilisent les propriétés magnétiques des atomes (leur spin) pour réaliser des mesures de rotation. A partir de la mesure de l'évolution des moments magnétiques d'atomes de gaz nobles, il est possible de calculer la rotation du gyroscope et donc celle du porteur auquel il est attaché. Cette mesure est entachée d'un certain nombre d'imperfections, la dérive de biais étant la plus significative d'entre elles. Lorsque cette dérive est de l'ordre de 0.01 degré/heure, le gyroscope est suffisamment précis pour servir à la navigation inertielle, c'est-à-dire, à la navigation indépendante de toute référence extérieure, réalisée par double intégration des accélérations mesurées sur le porteur.

Pour produire des atomes de gaz noble hyperpolarisés, les gyroscopes à spin atomique ont recours à la méthode de pompage optique par échange de spin SEOP. Cette méthode repose sur le transfert du moment angulaire de photons vers les spins électroniques d'atomes alcalins suivi du transfert, par collision, du moment angulaire de ces spins électroniques des atomes alcalins vers les spins nucléaires des atomes de gaz noble.

Les premiers gyroscopes atomiques à spin mis au point à la fin des années 1960 utilisent la résonance magnétique nucléaire (« Nuclear Magnetic Resonance » ou RMN). Pour cela, une ou plusieurs espèces sensibles contenue dans une cellule sont soumises de manière continue à un champ magnétique statique, ce qui induit une précession de leurs moments magnétiques à une fréquence caractéristique, dite de Larmor. Une variation de valeur de la fréquence de Larmor est le signe d'une rotation, et la grandeur de cette variation permet de mesurer la vitesse de rotation du gyroscope par rapport au référentiel inertiel.

Un autre type de gyroscope atomique à spin est développé depuis les années 2000. Il s'agit des co-magnétomètres qui sont basées sur un mélange entre un gaz noble et un ou plusieurs métaux alcalins, et qui contrairement aux gyroscopes RMN opèrent dans un régime où l'alcalin est soumis à un champ magnétique très proche de zéro (les éventuels champs magnétiques extérieurs étant annulés en créant des champs de compensation opposés). Cette architecture performante notamment dans l'article de T.W. Kornack et al. intitulé « Nuclear Spin Gyroscope Based on an Atomic Comagnetometer », Phys. Rev. Lett., vol. 95, no. 23, p. 230801, Nov. 2005.

Toutefois un inconvénient majeur de ce dispositif est son temps de démarrage qui, limité physiquement par la lenteur du processus d'échange de spin entre le métal alcalin (potassium par exemple) et le gaz noble (l'hélium par exemple), est de l'ordre de la dizaine d'heures, alors qu'une utilisation en situation réelle demande typiquement un temps de démarrage et un positionnement du nord inférieur à cinq minutes.

Ce temps de démarrage est lié à la constante de temps $\Gamma_{ex}^{-1}$ d'échange de spin entre le métal alcalin et le gaz noble, car la polarisation de ce dernier évolue comme : $P = P_{alk} \frac{\Gamma_{ex}}{\Gamma_{ex}+\Gamma_1} \left(1 - e^{-t(\Gamma_1 + \Gamma_{ex})}\right)$, où $P_{alk}$ est la polarisation du métal alcalin et $\Gamma_1$ le taux de relaxation du gaz noble par des phénomènes autres que l'échange.

Cet inconvénient a été identifié notamment par le groupe du professeur Fang (Université de Beihang, Chine) qui a mis en place un programme de recherche consistant à remplacer l'hélium 3 par un autre gaz noble, en l'occurrence le xénon 129, pour réduire le temps de démarrage à une trentaine de minutes comme par exemple décrit dans l'article de J. Fang et al. intitulé "A novel Cs-129Xe atomic spin gyroscope with closed-loop Faraday modulation," Review of Scientific Instruments, vol. 84, no. 8, p. 083108, Aug. 2013. Toutefois le remplacement de l'hélium 3 par le xénon 129 entraine une dégradation notable des performances du gyroscope. Or pour permettre la navigation inertielle, on vise une dérive de l'ordre de 0.01°/h et un angle de marche aléatoire (« angle of random-walk », ARW) de l'ordre de 0.002°/√h.

## EXPOSÉ DE L'INVENTION

L'invention a pour objectif de réduire le temps de démarrage d'un gyroscope atomique à spin atomique reposant sur un pompage de type SEOP, pour offrir un temps de démarrage compatible avec une utilisation en situation réelle de navigation inertielle sans pour autant en dégrader les performances.

Elle propose à cet effet un procédé de détection d'une rotation d'un porteur au moyen d'un dispositif embarqué dans le porteur et qui comporte une enceinte contenant un mélange gazeux d'un métal alcalin et d'un gaz noble. Le procédé comprend une étape de démarrage du dispositif au cours de laquelle le gaz noble est polarisé au moyen d'un pompage optique par échange de métastabilité. Suite à l'étape de démarrage, le procédé comprend une étape d'acquisition par le dispositif d'un signal représentatif de ladite rotation au cours de laquelle le gaz noble est maintenu polarisé au moyen d'un pompage optique par échange de spin.

Certains aspects préférés mais non limitatifs de ce procédé sont les suivants :

- l'étape de démarrage est achevée lorsque la polarisation conférée au gaz noble au moyen du pompage optique par échange de métastabilité correspond à une polarisation stationnaire conférée au gaz noble au moyen du pompage optique par échange de spin ;
- le pompage optique par échange de métastabilité comprend une excitation du gaz noble au moyen d'un premier laser pompe dont la puissance est asservie de façon à ce que la polarisation conférée au gaz noble au moyen du pompage optique par échange de métastabilité atteigne la polarisation stationnaire ;
- l'étape de démarrage comprend une sous-étape de test de polarisation comprenant :

   ◦ l'arrêt du pompage optique par échange de métastabilité ;
   ◦ le démarrage du pompage optique par échange de spin, la réalisation d'une première mesure de la polarisation du gaz noble suivie ultérieurement de la réalisation d'une deuxième mesure de la polarisation du gaz noble ;
   ◦ si le résultat de la deuxième mesure est supérieur au résultat de la première mesure, l'arrêt du pompage optique par échange de spin et le redémarrage du pompage optique par échange de métastabilité ; et
   ◦ si le résultat de la deuxième mesure est inférieur au résultat de la première mesure, l'étape de démarrage est achevée.

- lors de l'étape de démarrage, le pompage optique par échange de métastabilité est réalisé dans une cellule auxiliaire de l'enceinte reliée à une cellule principale de l'enceinte par une connexion de diffusion du mélange gazeux ;
- l'étape de démarrage comprend :

   ◦ la fermeture d'une première vanne agencée entre la cellule principale et une cellule intermédiaire agencée dans la connexion de diffusion du mélange gazeux; et

   ◦ l'ouverture d'une deuxième vanne agencée entre la cellule intermédiaire et la cellule auxiliaire.

L'invention s'étend à un procédé de navigation inertielle mettant en œuvre le procédé de détection d'une rotation du porteur.

L'invention porte également sur un dispositif de détection d'une rotation, comportant une enceinte contenant un mélange gazeux d'un métal alcalin et d'un gaz noble, et un premier système de polarisation du gaz noble configuré pour réaliser un pompage optique par échange de spin. Le dispositif comporte en outre un deuxième système de polarisation du gaz noble configuré pour réaliser un pompage optique par échange de métastabilité, et un contrôleur configuré pour mettre en œuvre les étapes de démarrage et d'acquisition en venant activer sélectivement respectivement le deuxième et le premier système de polarisation.

Le métal alcalin peut être du potassium et le gaz noble de l'hélium 3.

L'enceinte peut comprendre une cellule principale et une cellule auxiliaire reliée à la cellule principale par une connexion de diffusion du mélange gazeux, le deuxième système de polarisation étant configuré pour augmenter la polarisation du gaz noble dans l'enceinte auxiliaire et le premier système de polarisation étant configuré pour maintenir la polarisation du gaz noble dans l'enceinte principale.

L'enceinte peut également comprendre une cellule intermédiaire agencée dans la connexion de diffusion du mélange gazeux, une première vanne agencée entre la cellule principale et la cellule intermédiaire et une deuxième vanne agencée entre la cellule intermédiaire et la cellule auxiliaire, le contrôleur étant configuré pour, lors de l'étape de démarrage, fermer la première vanne et ouvrir la deuxième vanne.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- la figure 1 est un ordinogramme illustrant les principales étapes du procédé selon l'invention ;
- la figure 2 est un schéma d'une cellule pouvant être utilisée dans le dispositif selon l'invention.

## EXPOSÉ DÉTAILLÉ DE MODES DE RÉALISATION PARTICULIERS

L'invention porte sur un procédé de détection d'une rotation d'un porteur au moyen d'un dispositif embarqué dans le porteur. Le dispositif embarqué, typiquement un gyroscope atomique à spin, comprend une enceinte contenant un mélange gazeux d'un métal alcalin et d'un gaz noble. Ce dispositif est configuré pour acquérir un signal représentatif de la rotation du porteur, et plus précisément un signal représentatif d'un décalage de la précession des noyaux de gaz noble sous l'effet de la rotation.

Pour procéder à l'acquisition d'un tel signal, le gaz noble est maintenu polarisé à une polarisation d'équilibre au moyen d'un pompage optique SEOP par échange de spin. Toutefois, pour atteindre rapidement la polarisation d'équilibre du pompage SEOP et disposer ainsi d'un temps de démarrage bref du dispositif, un pompage rapide est réalisé par une autre technique, à savoir la méthode dite d'échange de métastabilité MEOP (pour « Metastability Exchange Optical Pumping »). Selon cette méthode, qui ne nécessite pas d'avoir recours à un métal alcalin comme intermédiaire de pompage, quelques atomes de gaz noble sont excités par une décharge électrique (plasma) à un état d'énergie métastable où ils peuvent absorber une lumière et être optiquement polarisés. L'échange de spin s'opère alors entre l'état excité métastable et l'état fondamental du gaz noble. Cette méthode est actuellement utilisée pour la production de volumes importants d'hélium hyperpolarisé pour des applications d'imagerie médicale. En revanche son utilisation dans les gyroscopes atomiques n'a pas été envisagée car en présence du plasma des nombreux effets indésirables se produisent, notamment des dérives importantes liées à l'interaction des différentes espèces excitées par le plasma avec celles qui sont mises en œuvre pour la mesure de rotation.

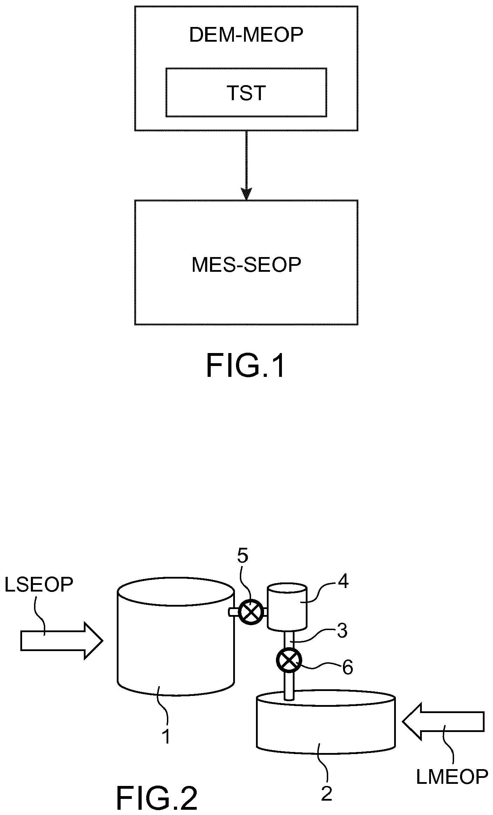

Ainsi, et en référence à la figure 1, l'invention propose un procédé de détection d'une rotation d'un porteur qui comprend une étape de démarrage « DEM-MEOP » du dispositif embarqué au cours de laquelle le gaz noble est polarisé au moyen d'un pompage optique par échange de métastabilité MEOP suivie d'une étape d'acquisition « MES-SEOP » par le dispositif embarqué d'un signal représentatif de ladite rotation au cours de laquelle le gaz noble est maintenu polarisé au moyen d'un pompage optique par échange de spin SEOP.

Dans ce procédé, on vient typiquement mettre fin à l'étape de démarrage « DEM-MEOP » et débuter l'étape de mesure « MES-SEOP » lorsque la polarisation conférée au gaz noble lors de l'étape de démarrage au moyen du pompage optique par échange de métastabilité correspond à la polarisation stationnaire conférée au gaz noble au moyen d'un pompage optique par échange de spin, à savoir $P_{alk} \frac{\Gamma_{ex}}{\Gamma_{ex}+\Gamma_1}$. En procédant de la sorte, on évite des transitoires au cours desquels la mesure ne serait pas optimale.

L'invention définit ainsi une étape de démarrage où une polarisation rapide est réalisée par pompage MEOP et une étape de mesure qui ne subit pas les imperfections induites par le plasma d'un pompage MEOP car réalisée en maintenant une polarisation stationnaire par pompage SEOP.

Pour ce faire, le dispositif dispose d'un premier système de polarisation du gaz noble configuré pour réaliser un pompage optique par échange de spin et d'un deuxième système de polarisation du gaz noble configuré pour réaliser un pompage optique par échange de métastabilité. Le dispositif est en outre équipé d'un contrôleur configuré pour mettre en œuvre le procédé de l'invention, notamment en venant :

- activer sélectivement le deuxième système de polarisation (pompage MEOP) et le contrôler afin d'augmenter la polarisation du gaz noble lors de l'étape de démarrage du dispositif; et

- activer sélectivement le premier système de polarisation (pompage SEOP) et le contrôler afin de maintenir la polarisation du gaz noble lors de l'étape d'acquisition du signal représentatif de la rotation consécutive à l'étape de démarrage.

L'enceinte renferme typiquement du potassium en tant que métal alcalin et de l'hélium 3 en tant que gaz noble.

Le premier système de polarisation SEOP comprend notamment un premier laser pompe, un laser sonde et un photodétecteur délivrant le signal représentatif de la rotation du porteur.

Le deuxième système de polarisation MEOP comprend des bobines enroulées sur la paroi de l'enceinte qui, alimentées par un signal radio-fréquence, permettent de réaliser un couplage inductif de cette radio-fréquence et de là d'induire une ionisation du mélange gazeux et donc de générer une décharge plasma à même de peupler l'état métastable de l'hélium 3 (noté $2^3S_1$). Ce deuxième système de polarisation comprend en outre un deuxième laser pompe apte à émettre un faisceau optique en direction de l'enceinte pour exciter l'hélium 3. Ce deuxième laser pompe est accordé à la transition entre l'état métastable $2^3S_1$ et l'état excité $2^3P$ de l'hélium 3, cette transition correspondant à une longueur d'onde de 1083 nm. Le contrôleur vient asservir la puissance du deuxième laser pompe de façon à ce que la polarisation conférée au gaz noble au moyen du pompage MEOP atteigne la polarisation stationnaire du pompage SEOP. Cet asservissement peut être réalisé en venant mesurer continûment la polarisation du gaz noble (par exemple en utilisant une bobine) et en rétroagissant sur la puissance du laser du pompage MEOP pour que la polarisation du gaz noble à l'issue de l'étape de démarrage corresponde à la polarisation stationnaire du pompage SEOP.

Le temps nécessaire pour atteindre cette valeur de polarisation stationnaire (durée de l'étape de démarrage) dépend de nombreux paramètres (pression dans l'enceinte, puissance du deuxième laser sonde, champ magnétique extérieur, etc.). Pour une enceinte typique, la durée de l'étape de démarrage est dans est dans la gamme 10-300s.

Il peut ne pas être aisé de donner une expression analytique fiable de cette durée de démarrage et donc de définir a priori et de façon précise à quel moment basculer de l'étape de démarrage à l'étape de mesure. Pour contourner cette difficulté, il est possible lors de l'étape de démarrage de venir réitérer une sous-étape de test de polarisation « TST » pour vérifier si la valeur de polarisation stationnaire a été atteinte ou non. Cette sous-étape peut comprendre l'arrêt du pompage MEOP, le démarrage du pompage SEOP, la réalisation d'une première mesure de la polarisation du gaz noble suivie ultérieurement, par exemple quelques secondes après, de la réalisation d'une deuxième mesure de la polarisation du gaz noble.

Si le résultat de la deuxième mesure est supérieur au résultat de la première mesure, le pompage SEOP a augmenté la polarisation. Celle-ci n'avait donc pas atteint sa valeur stationnaire, et le pompage MEOP doit être poursuivi. Ainsi, dans un tel cas de figure, la sous-étape de test de polarisation comprend l'arrêt du pompage SEOP et le redémarrage du pompage MEOP.

Si le résultat de la deuxième mesure est inférieur au résultat de la première mesure, la valeur stationnaire est atteinte, voire dépassée. Dans un tel cas de figure, l'étape de démarrage est achevée et l'étape de mesure débute en gardant le pompage SEOP allumé.

Les mesures de la polarisation du gaz noble peuvent être réalisées en venant détecter le champ magnétique créé par la polarisation du gaz noble. Pour ce faire, le dispositif peut être utilisé comme magnétomètre exploitant les résonances du métal alcalin lorsque l'on effectue son pompage optique dans un champ magnétique modulé en amplitude. Une telle procédure est par exemple décrite dans Cohen-Tannoudji et al. Revue de Physique Appliquée, vol. 5, no. 1, pp. 102-108, 1970.

Dans un tel cas de figure, chacune des deux mesures de la polarisation se déroule sur quelques périodes de caractérisation, la période de caractérisation correspondant au carré du produit de la polarisation stationnaire visée multipliée par le moment magnétique de l'hélium 3 contenu dans l'enceinte, divisé par le bruit du magnétomètre en unités de densité spectrale de puissance.

Dans une variante de réalisation, l'instant de commutation entre les étapes de démarrage et de mesure peut ne pas être détecté au moyen de mesures de la polarisation mais être prédéterminé en étant par exemple issue d'un apprentissage s'appuyant sur des enregistrements de paramètres de commutation alimentant un algorithme statistique.

Il est connu que les régimes pour lesquels le pompage MEOP sont les plus efficaces correspondent à de fortes intensités de radio-fréquence et de faibles pressions d'hélium.

Dans un mode de réalisation possible représenté sur la figure 2, l'enceinte comprend une cellule principale 1 et une cellule auxiliaire 2 reliée à la cellule principale par une connexion de diffusion du mélange gazeux 2 et dans laquelle une partie de l'hélium 3 est transférée. Le premier système de polarisation (SEOP) est configuré pour maintenir la polarisation du gaz noble dans l'enceinte principale 1, au moyen notamment d'un premier laser sonde LSEOP agencé de manière à venir éclairer la cellule principale 1. Le deuxième système de polarisation (MEOP) est quant à lui configuré pour augmenter la polarisation du gaz noble dans la cellule auxiliaire 2, au moyen notamment d'un second laser sonde MSEOP agencé de manière à venir éclairer la cellule auxiliaire 2 et de bobines (non représentées) entourant la cellule auxiliaire. Du fait notamment de l'absence de métal alcalin sur les parois de la cellule auxiliaire, il est possible d'y générer un plasma de haute intensité ce qui permet de raccourcir la durée nécessaire pour atteindre le niveau de polarisation désiré.

Dans une variante de ce mode de réalisation, une cellule intermédiaire 4 est agencée dans la connexion de diffusion du mélange gazeux 3. Cette cellule intermédiaire 4 présente un volume inférieur à celui de la cellule auxiliaire 2, par exemple un volume correspondant à 5-10% de celui de la cellule principale.

L'enceinte comprend également une première vanne 5 agencée entre la cellule principale 1 et la cellule intermédiaire 2 et une deuxième vanne 6 agencée entre la cellule intermédiaire 5 et la cellule auxiliaire 2. Le contrôleur du dispositif est par ailleurs configuré pour, lors de l'étape de démarrage, fermer la première vanne 5 et ouvrir la deuxième vanne 3. Ainsi en fermant la connexion à la cellule principale et en ouvrant celle vers la cellule auxiliaire de plus grand volume, une détente du gaz se produit qui permet d'abaisser la pression dans la proportion des volumes respectifs de la cellule intermédiaire et de la cellule auxiliaire pour atteindre le régime idéal de pression.

L'invention n'est pas limitée au procédé et au dispositif précédemment décrits mais s'étend également à une centrale de navigation inertielle incorporant un tel dispositif, ainsi qu'à un procédé de navigation inertielle mis en œuvre par une telle centrale et comprenant la réalisation du procédé de détection d'une rotation du porteur précédemment décrit.

## Revendications

1. Procédé de détection d'une rotation d'un porteur au moyen d'un dispositif embarqué dans le porteur et qui comporte une enceinte contenant un mélange gazeux d'un métal alcalin et d'un gaz noble, le procédé comprenant :

   - une étape de démarrage (DEM-MEOP) du dispositif au cours de laquelle le gaz noble est polarisé au moyen d'un pompage optique par échange de métastabilité ; et
   - suite à l'étape de démarrage, une étape d'acquisition (MES-SEOP) par le dispositif d'un signal représentatif de ladite rotation au cours de laquelle le gaz noble est maintenu polarisé au moyen d'un pompage optique par échange de spin.

2. Procédé selon la revendication 1, dans lequel l'étape de démarrage est achevée lorsque la polarisation conférée au gaz noble au moyen du pompage optique par échange de métastabilité correspond à une polarisation stationnaire conférée au gaz noble au moyen du pompage optique par échange de spin.

3. Procédé selon la revendication 2, dans lequel le pompage optique par échange de métastabilité comprend une excitation du gaz noble au moyen d'un premier laser pompe dont la puissance est asservie de façon à ce que la polarisation conférée au gaz noble au moyen du pompage optique par échange de métastabilité atteigne la polarisation stationnaire.

4. Procédé selon la revendication 2, dans lequel l'étape de démarrage comprend une sous-étape de test de polarisation (TST) comprenant :

   - l'arrêt du pompage optique par échange de métastabilité ;
   - le démarrage du pompage optique par échange de spin, la réalisation d'une première mesure de la polarisation du gaz noble suivie ultérieurement de la réalisation d'une deuxième mesure de la polarisation du gaz noble ;
   - si le résultat de la deuxième mesure est supérieur au résultat de la première mesure, l'arrêt du pompage optique par échange de spin et le redémarrage du pompage optique par échange de métastabilité ; et
   - si le résultat de la deuxième mesure est inférieur au résultat de la première mesure, l'étape de démarrage est achevée.

5. Procédé selon l'une des revendications 1 à 4, dans lequel, lors de l'étape de démarrage, le pompage optique par échange de métastabilité est réalisé dans une cellule auxiliaire (2) de l'enceinte reliée à une cellule principale (1) de l'enceinte par une connexion de diffusion du mélange gazeux (3).

6. Procédé selon la revendication 5, dans lequel l'étape de démarrage comprend :

   - la fermeture d'une première vanne (5) agencée entre la cellule principale (1) et une cellule intermédiaire (4) agencée dans la connexion de diffusion du mélange gazeux ; et
   - l'ouverture d'une deuxième vanne (6) agencée entre la cellule intermédiaire (4) et la cellule auxiliaire (2).

7. Dispositif de détection d'une rotation, comportant une enceinte contenant un mélange gazeux d'un métal alcalin et d'un gaz noble, et un premier système de polarisation du gaz noble configuré pour réaliser un pompage optique par échange de spin, **caractérisé en ce qu'**il comporte en outre un deuxième système de polarisation du gaz noble configuré pour réaliser un pompage optique par échange de métastabilité, et un contrôleur configuré pour :

   - lors d'une étape de démarrage du dispositif, activer sélectivement le deuxième système de polarisation et le contrôler afin d'augmenter la polarisation du gaz noble ; et
   - lors d'une étape d'acquisition par le dispositif d'un signal représentatif de ladite rotation, consécutive à l'étape de démarrage, activer sélectivement le premier système de polarisation et le contrôler afin de maintenir la polarisation du gaz noble.

8. Dispositif selon la revendication 7, dans lequel le métal alcalin est du potassium et le gaz noble est de l'hélium 3.

9. Dispositif selon l'une des revendications 7 et 8, dans lequel l'enceinte comprend une cellule principale et une cellule auxiliaire reliée à la cellule principale par une connexion de diffusion du mélange gazeux, et dans lequel le deuxième système de polarisation est configuré pour augmenter la polarisation du gaz noble dans l'enceinte auxiliaire et le premier système de polarisation est configuré pour maintenir la polarisation du gaz noble dans l'enceinte principale.

10. Dispositif selon la revendication 9, comprenant en outre une cellule intermédiaire agencée dans la connexion de diffusion du mélange gazeux, une première vanne agencée entre la cellule principale et la cellule intermédiaire et une deuxième vanne agencée entre la cellule intermédiaire et la cellule auxiliaire, et dans lequel le contrôleur est en outre configuré pour, lors de l'étape de démarrage, fermer la première vanne et ouvrir la deuxième vanne.

11. Centrale de navigation inertielle comprenant un dispositif selon l'une des revendications 7 à 10.

12. Procédé de navigation inertielle comprenant la détection d'une rotation d'un porteur conformément au procédé selon l'une des revendications 1 à 6.

**Patentansprüche**

1. Verfahren zur Detektion einer Drehung eines Trägers mit Hilfe einer Vorrichtung, die in dem Träger mitgeführt wird und die ein Gehäuse aufweist, das ein gasförmiges Gemisch aus einem Alkalimetall und einem Edelgas beinhaltet, wobei das Verfahren umfasst:

- einen Schritts des Anlaufens (DEM-MEOP) der Vorrichtung, während dem das Edelgas mittels optischen Pumpens durch Metastabilitätsaustausch polarisiert wird; und
- nach dem Schritt des Anlaufens einen Schritt des Erfassens (MES-SEOP) eines Signals durch die Vorrichtung, welches Signals repräsentativ ist für die Drehung, während dem das Edelgas mittels optischen Pumpens durch Spinaustausch polarisiert gehalten wird.

2. Verfahren nach Anspruch 1, wobei der Anlaufschritt abgeschlossen ist, wenn die dem Edelgas mittels optischen Pumpens durch Metastabilitätsaustausch verliehene Polarisation einer stationären Polarisation entspricht, die dem Edelgas mittels optischen Pumpens durch Spinaustausch verliehen wurde.

3. Verfahren nach Anspruch 2, wobei das optische Pumpen durch Metastabilitätsaustausch ein Anregen des Edelgases mittels eines ersten Pumplasers umfasst, dessen Leistung so gesteuert wird, dass die dem Edelgas mittels optischen Pumpens durch Metastabilitätsaustausch verliehene Polarisation die stationäre Polarisation erreicht.

4. Verfahren nach Anspruch 2, wobei der Anlaufschritt einen Teilschritt des Polarisationstests (TST) umfasst, umfassend:

- Anhalten des optischen Pumpens durch Metastabilitätsaustausch;
- Starten des optischen Pumpens durch Spinaustausch, Durchführen einer ersten Messung der Polarisation des Edelgases und anschließendes Durchführen einer zweiten Messung der Polarisation des Edelgases;
- wenn das Ergebnis der zweiten Messung größer ist als das Ergebnis der ersten Messung, Anhalten des optischen Pumpens durch Spinaustausch und Neustarten des optischen Pumpens durch Metastabilitätsaustausch; und
- wenn das Ergebnis der zweiten Messung niedriger ist als das Ergebnis der ersten Messung, Abschließen des Anlaufschritts.

5. Verfahren nach einem der Ansprüche 1 bis 4, wobei beim Anlaufschritt das optische Pumpen durch Metastabilitätsaustausch in einer Hilfszelle (2) des Gehäuses durchgeführt wird, die über eine Gasgemisch-Diffusionsverbindung (3) mit einer Hauptzelle (1) des Gehäuses verbunden ist.

6. Verfahren nach Anspruch 5, wobei der Anlaufschritt umfasst:

- Schließen eines ersten Ventils (5), das zwischen der Hauptzelle (1) und einer Zwischenzelle (4) angeordnet ist, die in der Gasgemisch-Diffusionsverbindung angeordnet ist; und
- Öffnen eines zweiten Ventils (6), das zwischen der Zwischenzelle (4) und der Hilfszelle (2) angeordnet ist.

7. Vorrichtung zur Detektion einer Drehung, enthaltend ein Gehäuse, das ein gasförmiges Gemisch aus einem Alkalimetall und einem Edelgas beinhaltet, und ein erstes Edelgas-Polarisationssystem, das dazu ausgelegt ist, ein optisches Pumpen durch Spinaustausch durchzuführen,
**dadurch gekennzeichnet, dass**
sie ferner ein zweites Edelgas-Polarisationssystem enthält, das dazu ausgelegt ist, ein optisches Pumpen durch Metastabilitätsaustausch durchzuführen, sowie eine Steuerung, die dazu ausgelegt ist,

- während eines Schrittes des Anlaufens der Vorrichtung das zweite Polarisationssystem selektiv zu aktivieren und zu steuern, um die Polarisation des Edelgases zu erhöhen; und
- während eines Schrittes der Erfassung eines für die Drehung repräsentativen Signals durch die Vorrichtung nach dem Anlaufschritt selektiv das erste Polarisationssystem zu aktivieren und zu steuern, um die Polarisation des Edelgases aufrechtzuerhalten.

8. Vorrichtung nach Anspruch 7, wobei das Alkalimetall Kalium und das Edelgas Helium 3 ist.

9. Vorrichtung nach einem der Ansprüche 7 und 8, wobei das Gehäuse eine Hauptzelle und eine Hilfszelle aufweist, die mit der Hauptzelle über eine Gasgemisch-Diffusionsverbindung verbunden ist, und wobei das zweite Polarisationssystem dazu ausgelegt ist, die Polarisation des Edelgases in dem Hilfsgehäuse zu erhöhen, und das erste Polarisationssystem dazu ausgelegt ist, die Polarisation des Edelgases in dem Hauptgehäuse aufrechtzuerhalten.

10. Vorrichtung nach Anspruch 9, ferner enthaltend eine Zwischenzelle, die in der Gasgemisch-Diffusionsverbindung angeordnet ist, ein erstes Ventil, das zwischen der Hauptzelle und der Zwischenzelle angeordnet ist, und ein zweites Ventil, das zwischen der Zwischenzelle und der Hilfszelle angeordnet ist, wobei die Steuerung ferner dazu ausgelegt ist, im Anlaufschritt das erste Ventil zu schließen und das zweite Ventil zu öffnen.

11. Trägheitsnavigationssystem mit einer Vorrichtung nach einem der Ansprüche 7 bis 10.

**12.** Trägheitsnavigationsverfahren, umfassend die Detektion einer Drehung eines Trägers gemäß dem Verfahren nach einem der Ansprüche 1 bis 6.

## Claims

**1.** A method for detecting rotation of a carrier by a device embedded in said carrier, said device comprising an enclosure containing a gaseous mixture of an alkali metal and a noble gas, the method including:

- a step of starting up (DEM-MEOP) the device during which the noble gas is polarised by means of metastability exchange optical pumping; and
- following the step of starting up, a step of acquiring (MES-SEOP), by the device, a signal representative of said rotation during which the noble gas is maintained polarised by means of spin exchange optical pumping.

**2.** The method according to claim 1, wherein the step of starting up is finished when the polarisation conferred on the noble gas by means of the metastability exchange optical pumping corresponds to a stationary polarisation conferred on the noble gas by means of the spin exchange optical pumping.

**3.** The method according to claim 2, wherein the metastability exchange optical pumping includes an excitation of the noble gas by means of a first pump laser of which the power is controlled in such a way that the polarisation conferred on the noble gas by means of the metastability exchange optical pumping reaches the stationary polarisation.

**4.** The method according to claim 2, wherein the step of starting up includes a sub-step of testing polarisation (TST) which includes:

- stopping the metastability exchange optical pumping;
- starting up the spin exchange optical pumping, carrying out a first measurement of the polarisation of the noble gas followed later by carrying out a second measurement of the polarisation of the noble gas;
- if the result of the second measurement is greater than the result of the first measurement, stopping the spin exchange optical pumping and starting up again the metastability exchange optical pumping; and
- if the result of the second measurement is less than the result of the first measurement, the step of starting up is finished.

**5.** The method according to one of claims 1 to 4, wherein, during the step of starting up, the metastability exchange optical pumping is carried out in an auxiliary cell (2) of the enclosure connected to a main cell (1) of said enclosure by a diffusion connection (3) of the gaseous mixture.

**6.** The method according to claim 5, wherein the step of starting up includes:

- closing a first valve (5) arranged between the main cell (1) and an intermediate cell (4) arranged in the diffusion connection of the gaseous mixture; and
- opening a second valve (6) arranged between the intermediate cell (4) and the auxiliary cell (2).

**7.** A device for detecting rotation, comprising an enclosure containing a gaseous mixture of an alkali metal and a noble gas, a first system for polarising the noble gas configured to carry out spin exchange optical pumping, and a second system for polarising the noble gas configured to carry out metastability exchange optical pumping, and a controller configured to:

- during a step of starting up the device, selectively activating and controlling the second polarisation system in order to increase the polarisation of the noble gas; and
- during a step, consecutive to the step of starting up, of acquiring, by the device, a signal representative of said rotation, selectively activating and controlling the first polarisation system in order to maintain the polarisation of the noble gas.

**8.** The device according to claim 7, wherein the alkali metal is potassium and the noble gas is helium 3.

**9.** The device according to one of claims 7 and 8, wherein the enclosure includes a main cell and an auxiliary cell connected to the main cell by a diffusion connection of the gaseous mixture, and wherein the second polarisation system is configured to increase the polarisation of the noble gas in the auxiliary enclosure and the first polarisation system is configured to maintain the polarisation of the noble gas in the main enclosure.

**10.** The device according to claim 9, further including an intermediate cell arranged in the diffusion connection of the gaseous mixture, a first valve arranged between the main cell and the intermediate cell and a second valve arranged between the intermediate cell and the auxiliary cell, and wherein the controller is further configured, during the start-up step, to close the first valve and open the second valve.

11. An inertial navigation unit including a device according to any one of claims 7 to 10.

12. An inertial navigation method including the detection of a rotation of a carrier in accordance with the method according to any one of claims 1 to 6.

DEM-MEOP

TST

MES-SEOP

# FIG.1

LSEOP

5

4

3

6

1

2

LMEOP

# FIG.2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Littérature non-brevet citée dans la description**

- **T.W. KORNACK et al.** Nuclear Spin Gyroscope Based on an Atomic Comagnetometer. *Phys. Rev. Lett.,* Novembre 2005, vol. 95 (23), 230801

- **J. FANG et al.** A novel Cs-129Xe atomic spin gyroscope with closed-loop Faraday modulation. *Review of Scientific Instruments,* Août 2013, vol. 84 (8), 083108
- **COHEN-TANNOUDJI et al.** *Revue de Physique Appliquée,* 1970, vol. 5 (1), 102-108